# EUROPEAN PATENT SPECIFICATION

(11) **EP 3 370 917 B1**
(45) Date of publication and mention of the grant of the patent: **12.06.2024**
(21) Application number: 16862819.6
(22) Date of filing: 02.11.2016
(51) Int. Cl.: B24B 37/20, B24B 37/22, B24B 37/24, B24B 37/26, C09K 3/14, H01L 21/321, B24B 37/16

(54) **POLISHING PAD WITH FOUNDATION LAYER AND WINDOW ATTACHED THERETO**
POLIERKISSEN MIT FUNDAMENTSCHICHT UND DARAN BEFESTIGTEM FENSTER
TAMPON DE POLISSAGE DOTÉ D'UNE COUCHE DE BASE ET D'UNE FENÊTRE FIXÉE SUR LADITE COUCHE

(30) Priority: 03.11.2015 US 201514931737
(43) Date of publication of application: 12.09.2018
(73) Proprietor: CMC Materials LLC, Wilmington, DE 19801 (US)
(72) Inventor: LEFEVRE, Paul Andre, Aurora, IL 60504 (US); ALLISON, William C., Aurora, IL 60504 (US); SCOTT, Diane, Aurora, IL 60504 (US); ARNO, Jose, Aurora, IL 60504 (US)
(74) Representative: Barker Brettell LLP
(86) International application number: PCT/US2016/059985
(87) International publication number: WO 2017/079196

(56) References cited:
- EP-A1- 1 306 163
- EP-B1- 1 638 735
- WO-A2-2010/082992
- JP-A- 2004 260 156
- JP-A- 2009 060 044
- US-A1- 2005 266 771
- US-A1- 2005 266 771
- US-A1- 2010 269 417
- US-A1- 2011 256 818
- US-A1- 2014 065 932
- US-A1- 2015 273 655
- US-A1- 2015 273 655
- US-B2- 9 102 034

## Description

### TECHNICAL FIELD

The present invention relates to the field of chemical mechanical polishing (CMP) and, in particular, to polishing pads having a foundation layer and a window attached to the foundation layer, such as those disclosed in US9102034 B2.

### BACKGROUND

Chemical-mechanical planarization or chemical-mechanical polishing, commonly abbreviated CMP, is a technique used in semiconductor fabrication for planarizing a semiconductor wafer or other substrate.

The process uses an abrasive and corrosive chemical slurry (commonly a colloid) in conjunction with a polishing pad and retaining ring, typically of a greater diameter than the wafer. The polishing pad and wafer are pressed together by a dynamic polishing head and held in place by a plastic retaining ring. The dynamic polishing head is rotated during polishing. This approach aids in removal of material and tends to even out any irregular topography, making the wafer flat or planar. This may be necessary in order to set up the wafer for the formation of additional circuit elements. For example, this might be necessary in order to bring the entire surface within the depth of field of a photolithography system, or to selectively remove material based on its position. Typical depth-of-field requirements are down to Angstrom levels for the latest sub-50 nanometer technology nodes.

The process of material removal is not simply that of abrasive scraping, like sandpaper on wood. The chemicals in the slurry also react with and/or weaken the material to be removed. The abrasive accelerates this weakening process and the polishing pad helps to wipe the reacted materials from the surface. In addition to advances in slurry technology, the polishing pad plays a significant role in increasingly complex CMP operations.

However, additional improvements are needed in the evolution of CMP pad technology.

### SUMMARY

The present invention relates to a polishing pad according to claim 1. Also disclosed but not part of the invention are methods of fabricating such polishing pads.

A method of fabricating a polishing pad for polishing a substrate includes forming a first opening through a polishing layer. The polishing layer has a polishing side and a back side and having a modulus. The method further includes attaching a foundation layer to the back side of the polishing layer. The foundation layer has a modulus greater than the modulus of the polishing layer. The method further includes, subsequent to attaching the foundation layer to the back side of the polishing layer, forming a second opening through the foundation layer. The first opening exposes at least a portion of the second opening and exposes a portion of the foundation layer. The method further includes inserting a window in the first opening and attaching the window to the exposed portion of the foundation layer.

A method of fabricating a polishing pad for polishing a substrate includes forming a first opening through a polishing layer. The polishing layer has a polishing side and a back side and has a modulus. The method also includes forming a second opening through a foundation layer. The foundation layer has a polishing side and a back side and has a modulus greater than the modulus of the polishing layer. The method also includes attaching a window to the polishing side of the foundation layer. The window covers at least a portion of the second opening. The method also includes, subsequent to attaching the window to the polishing side of the foundation layer, attaching the polishing layer to the foundation layer. The first opening formed through the polishing layer surrounds the window.

### BRIEF DESCRIPTION OF THE DRAWINGS

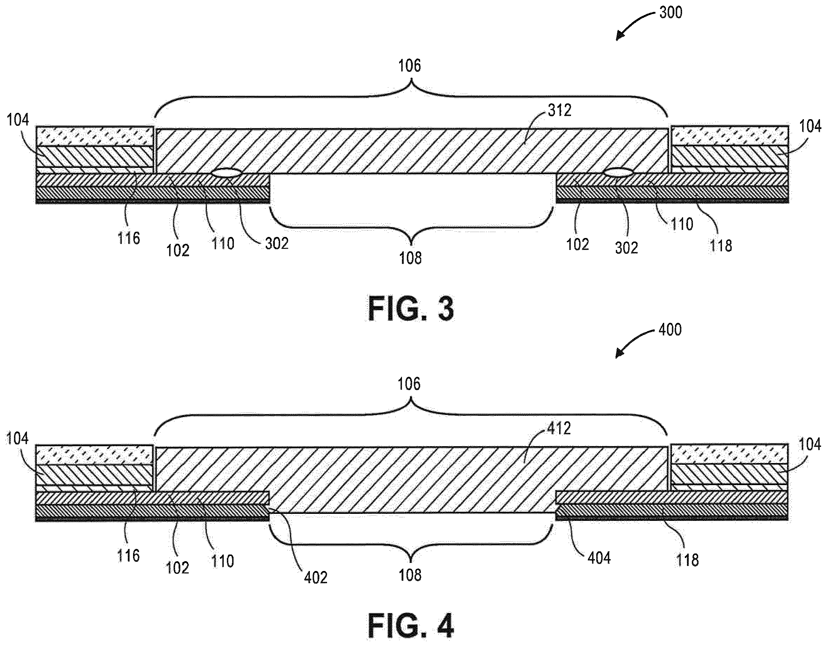

Of the following Figures, only Figure 4 illustrates the invention according to the appended claims.
Figure 1A illustrates a cross-sectional view, taken along the A-A' axis of Figure 1B, of a polishing pad with a window housed within an opening in a polishing layer and attached with an adhesive layer to an underlying foundation layer. Figure 1B illustrates a plan view of the polishing pad of Figure 1A.
Figures 2A-2I illustrate cross-sectional views representing various operations in a method of fabricating a polishing pad for polishing a substrate.
Figure 3 illustrates a cross-sectional view of a polishing pad with a window housed within an opening in a polishing layer and attached to an underlying foundation layer by a welded region.
Figure 4 illustrates a cross-sectional view of a polishing pad with a window housed within an opening in a polishing layer and attached to an underlying foundation layer by a snap-fit arrangement, in accordance with the present invention.
Figures 5A-5C illustrate cross-sectional views representing various operations in another method of fabricating a polishing pad for polishing a substrate.
Figure 6 illustrates an isometric side-on view of a polishing apparatus compatible with a polishing pad described herein.

### DETAILED DESCRIPTION

Polishing pads having a foundation layer and a window attached to the foundation layer, and methods of fabricating such polishing pads, are described herein. In the following description, numerous specific details are set forth, such as specific polishing pad architectures, designs and compositions, in order to provide a thorough understanding of embodiments of the present invention. It will be apparent to one skilled in the art that embodiments of the present invention may be practiced without these specific details. In other instances, well-known processing techniques, such as details concerning the combination of a slurry with a polishing pad to perform CMP of a semiconductor substrate, are not described in detail in order to not unnecessarily obscure embodiments of the present invention. Furthermore, it is to be understood that the various embodiments shown in the figures are illustrative representations and are not necessarily drawn to scale.

One or more examples described herein are directed to polishing pads having a window attached to an underlying to the foundation layer of the polishing pad. The window provides an avenue for optical end-point detection of a CMP process as monitored through the polishing pad, even in the case that the polishing pad includes an opaque polishing layer.

To provide context, traditional approaches to incorporating a window into a polishing pad have included attaching the window to an underlying sub pad. However, the sub pad is typically a low density foam (or low density impregnated felt) and does not necessarily offer good mechanical strength. For example, attaching the window to a sub pad has been known to lead to window issues during CMP processing, such as slurry leakage and window pop-out. Another approach has been to attach the window to the pad itself. However, such an approach requires that the pad is thicker than the window, which can lead to either an overly thin window or an overly thick pad. An overly thin window can lead to CMP issues at the end of the pad life. An overly thick pad, on the other hand, provides limited design options for tuning CMP performance. One or more embodiments, described herein address such issues by including a window attached to a foundation layer of a polishing pad.

To provide further context, polishing pads for CMP operations may have trade-offs in performance such as a trade-off between across-wafer polishing uniformity versus within die polishing uniformity. For example, hard polishing pads may exhibit good die-level planarization, but poor across-wafer uniformity. They may also scratch a substrate being polished. On the other hand, soft polishing pads may exhibit poor die-level planarization (e.g., they may cause dishing within die), but good wafer-level uniformity. An approach to mitigating the above performance trade-off may be to decouple within-wafer and within-die polishing effects. One or more embodiments, described herein address such issues by including a foundation layer together with a polishing layer.

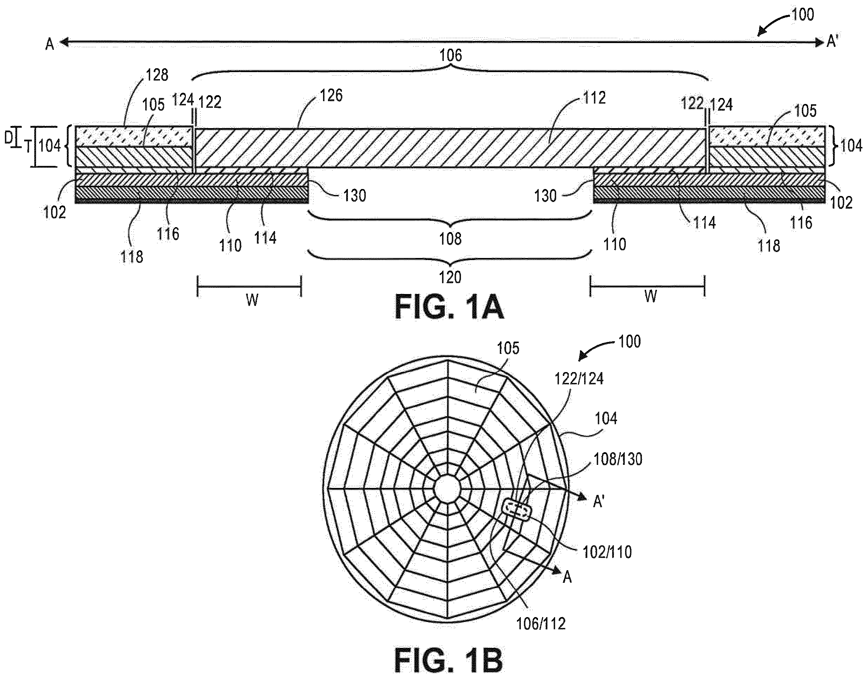

A first exemplary polishing pad includes a foundation layer having a window attached to the foundation layer by an adhesive layer. For example, Figure 1A illustrates a cross-sectional view, taken along the A-A' axis of Figure 1B, of a polishing pad with a window housed within an opening in a polishing layer and attached with an adhesive layer to an underlying foundation layer. Figure 1B illustrates a plan view of the polishing pad of Figure 1A.

Referring to Figures 1A and 1B, a polishing pad 100 for polishing a substrate includes a foundation layer 102 having a first modulus. A polishing layer 104 is attached to the foundation layer 102. The polishing layer 104 has a second modulus less than the first modulus. A first opening 106 is through the polishing layer 104. A second opening 108 is through the foundation layer 102. From a plan view perspective, the first opening 106 exposes at least a portion of the second opening 108 and exposes a portion 110 of the foundation layer 102. The first opening 106 may expose the entire second opening 108, as is depicted in Figures 1A and 1B. A window 112 is disposed in the first opening 106 and is attached to the exposed portion 110 of the foundation layer 102.

With reference to Figure 1A, the window 112 may be attached to the exposed portion 110 of the foundation layer 102 by an adhesive layer 114. The adhesive layer 114 may be one such as, but not limited to a pressure sensitive adhesive (PSA) layer, a two-component epoxy layer, a UV-cured resin layer, a silicone-based adhesive layer, a transfer tape layer, or a hot melt layer. The adhesive layer 114 may be a non-differential two-sided tape PSA layer. Alternatively, the adhesive layer 114 may be a first two-sided tape PSA layer, and the polishing layer 104 is attached to the foundation layer 102 using a second two-sided tape PSA layer 116. The second two-sided tape PSA layer 116 may have a thickness approximately the same as a thickness of the first two-sided tape PSA layer 114 attaching the window 112 to the foundation layer 102, as is depicted in Figure 1A. Alternatively, the adhesive layer 114 may be a differential two-sided tape PSA layer.

Referring again to Figure 1A, the polishing pad 100 may further include a sub pad 118 attached to the foundation layer 102 on a side of the foundation layer 102 opposite the polishing layer 104. A third opening 120 may be through the sub pad 118. The third opening 120 is substantially sized and aligned with the second opening 108, as is depicted in Figure 1A. The sub pad 118 may be composed of a material such as, but not limited to, foam, rubber, fiber, felt or a highly porous material. The sub pad 118 may have a hardness less than approximately 90 Shore A.

Referring again to Figure 1A, the window 112 may be substantially planar on both upper and lower surfaces. In one such example, no portion of the window 112 extends into the second opening 108, as is depicted in Figure 1A. In another example, however, a portion of the window 112 is disposed in the second opening. For example, the window may be described as a T-shaped plug for the openings 106 and 108.

Referring to Figure 1B, from a plan view perspective of the polishing layer 104, the window 112 may have substantially a same shape as the first opening 108. The shape may be one such as, but not limited to, a circle, an oval, a square, a rectangle, and a rectangle having rounded corners (the last embodiment depicted in the example illustrated in Figure 1B). Referring to Figure 1A, a perimeter 122 of the window 112 may be reduced in size at all portions of the perimeter by an amount approximately in the range of 5 - 15 mils relative to a perimeter 124 of the first opening 106. That is, the window 112 is sized to fit in opening 106 without contacting the polishing layer 104, or at least without contacting the polishing layer 104 at all surfaces of the perimeter 122 of the window 112. The window 112 may have an uppermost surface 126 lower than an uppermost surface 128 of the polishing layer 104. That is, the window 112 is recessed relative to the polishing layer 104, as is depicted in Figure 1A.

Referring again to Figure 1B, from a plan view perspective of the polishing layer 104, the first opening 106 may have substantially a same shape as the second opening 108. A perimeter 130 of the second opening 108 may be reduced in size at all portions of the perimeter by an amount approximately in the range of 10 - 500 mils relative to the perimeter 124 of the first opening 106. In a particular example, the perimeter 130 of the second opening 108 is reduced in size at all portions of the perimeter by an amount approximately in the range of 100 - 300 mils relative to the perimeter 124 of the first opening 106. With reference to Figure 1A, the exposed portions 110 of the foundation layer 102 may have a width (W) approximately in the range of 100 - 300 mils and, preferably, approximately in the range of 100 - 300 mils.

The window 112 may be composed of a material transparent to a broad spectrum irradiation approximately in the range of 300 - 800 nanometers. The window 112 may be composed of a material such as, but not limited to, a polyethylene terephthalate material, a polyurethane material, a cyclic olefin copolymer material, a polycarbonate material, a polyester material, a polypropylene material, or a polyethylene material.

The foundation layer 102 may be composed of a material such as, but not limited to, a polycarbonate material, an epoxy board material, a polyurethane material, a composite fiber board, a polymethylmethacrylate (PMMA) material, or a cyclic olefin copolymer material. The foundation layer 102 may have an energy loss factor of less than approximately 100 KEL at 1/Pa at 40°C. KEL is parameter for predicting polishing performance. ASTM D4092-90 ("Standard Terminology Relating to Dynamic Mechanical Measurements of Plastics") defines this parameter as the energy per unit volume lost in each deformation cycle. In other words, it is a measure of the area within the stress-strain hysteresis loop. The Energy Loss Factor (KEL) is a function of both tan δ and the elastic storage modulus (E') and may be defined by the following equation: KEL = tan δ*10¹²/[E'*(1 + tan δ²)] where E' is in Pascals. The ratio of elastic stress to strain is the storage (or elastic) modulus and the ratio of the viscous stress to strain is the loss (or viscous) modulus. When testing is performed in tension, flex, or compression, E' and E" designate the storage and loss modulus, respectively. The ratio of the loss modulus to the storage modulus is the tangent of the phase angle shift (δ) between the stress and the strain. Thus, E"/E' = tan δ and is a measure of the damping ability of the material.

The polishing layer 104 may be composed of a thermoset polyurethane material. For example, the foundation layer 102 may be composed of a polycarbonate layer, and the window 112 is composed of a polyethylene terephthalate material. The polishing layer 104 may have an energy loss factor of greater than approximately 1000 KEL at 1/Pa at 40°C. Referring to Figures 1A and 1B, the polishing layer 104 may have grooves 105 disposed therein. For example, the grooves 105 may be formed to a depth (D) of approximately 10%-60% of a total thickness (T) of the polishing layer 104. The grooves 105 may be formed to a depth (D) of approximately half of the total thickness (T) of the polishing layer 104. The grooves 105 may have a pattern of concentric polygons and radial grooves, as is depicted in Figure 1B. Alternatively, the radial grooves may be omitted. It is to be appreciated that other design choices for a pattern of grooves 105 may also be used.

The polishing layer 104 may be a homogeneous polishing layer. For example, the homogeneous polishing layer may be composed of a thermoset polyurethane material. In a specific example, the homogeneous polishing layer may be composed of a thermoset, closed cell polyurethane material. The term "homogeneous" may be used to indicate that the composition of a thermoset, closed cell polyurethane material is consistent throughout the entire composition of the polishing layer 104. For example, the term "homogeneous" may exclude polishing layers composed of, e.g., impregnated felt or a composition (composite) of multiple layers of differing material. The term "thermoset" may be used to indicate a polymer material that irreversibly cures, e.g., the precursor to the material changes irreversibly into an infusible, insoluble polymer network by curing. For example, the term "thermoset" may exclude polishing pads composed of, e.g., "thermoplast" materials or "thermoplastics" - those materials composed of a polymer that turns to a liquid when heated and returns to a very glassy state when cooled sufficiently. It is noted that polishing pads made from thermoset materials are typically fabricated from lower molecular weight precursors reacting to form a polymer in a chemical reaction, while pads made from thermoplastic materials are typically fabricated by heating a pre-existing polymer to cause a phase change so that a polishing pad is formed in a physical process. Polyurethane thermoset polymers may be selected for fabricating polishing pads described herein based on their stable thermal and mechanical properties, resistance to the chemical environment, and tendency for wear resistance. Although the polishing layer 104 is composed of a thermoset material, the corresponding foundation layer 102 may be composed of a thermoplastic material, such as a polycarbonate.

The material of polishing layer 104 may be molded. The term "molded" may be used to indicate that the polishing layer 104 is formed in a formation mold. The molded polishing layer 104, upon conditioning and/or polishing, may have a polishing surface roughness approximately in the range of 1 - 5 microns root mean square. The molded polishing layer 104, upon conditioning and/or polishing, may have a polishing surface roughness of approximately 2.35 microns root mean square.

The material of polishing layer 104 may include pore-forming features. The polishing layer 104 may have a pore density of closed cell pores approximately in the range of 6% - 50% total void volume. The plurality of closed cell pores may be a plurality of porogens. For example, the term "porogen" may be used to indicate micro- or nano-scale spherical or somewhat spherical particles with "hollow" centers. The hollow centers are not filled with solid material, but may rather include a gaseous or liquid core. The plurality of closed cell pores may be composed of pre-expanded and gas-filled EXPANCEL^{™} distributed throughout (e.g., as an additional component in) the polishing layer 104 of the polishing pad 100. For example, the EXPANCEL^{™} may be filled with pentane. Each of the plurality of closed cell pores may have a diameter approximately in the range of 10 - 100 microns. The plurality of closed cell pores may include pores that are discrete from one another. This is in contrast to open cell pores which may be connected to one another through tunnels, such as the case for the pores in a common sponge. Each of the closed cell pores may include a physical shell, such as a shell of a porogen, as described above. Alternatively, each of the closed cell pores may not include a physical shell. The plurality of closed cell pores may be distributed essentially evenly throughout a thermoset polyurethane material of the polishing layer 104. In an example, although the polishing layer 104 includes pore-forming features, the corresponding foundation layer 102 does not and is non-porous.

The polishing layer 104 may be opaque. The term "opaque" may be used to indicate a material that allows approximately 10% or less visible light to pass. The polishing layer 104 may be opaque in most part, or due entirely to, the inclusion of an opacifying particle filler, such as a lubricant, throughout (e.g., as an additional component in) the polishing layer 104. The opacifying particle filler may be a material such as, but not limited to boron nitride, cerium fluoride, graphite, graphite fluoride, molybdenum sulfide, niobium sulfide, talc, tantalum sulfide, tungsten disulfide, or Teflon^{®}.

The grooves 105 of the polishing layer 104 may have a pattern suitable for polishing during a CMP operation. Individual grooves 105 may be from about 2 to about 100 mils wide at any given point on each groove. The grooves 105 may be about 15 to about 50 mils wide at any given point on each groove. The grooves 105 may be of uniform width, variable width, or any combinations thereof. The grooves 105 of a groove pattern may all be of uniform width. Alternatively, some of the grooves 105 of a groove pattern may have a certain uniform width, while other grooves of the same pattern may have a different uniform width. Groove width may increase with increasing distance from the center of the polishing layer 104. Groove width may decrease with increasing distance from the center of the polishing layer 104. Grooves 105 of uniform width may alternate with grooves 105 of variable width.

In accordance with the previously described depth and width dimensions, individual grooves 105 may be of uniform volume, variable volume, or any combinations thereof. The grooves 105 may all be of uniform volume. Alternatively, groove volume may increase with increasing distance from the center of the polishing layer 104. Alternatively, groove volume may decrease with increasing distance from the center of the polishing layer 104. Grooves of uniform volume may alternate with grooves of variable volume.

Grooves 105 of the groove patterns described herein may have a pitch from about 30 to about 1000 mils. In some embodiments, the grooves 105 have a pitch of about 125 mils. For a circular polishing layer 104, groove pitch is measured along the radius of the circular polishing layer 104. In CMP belts, groove pitch is measured from the center of the CMP belt to an edge of the CMP belt. The grooves 105 may be of uniform pitch, variable pitch, or in any combinations thereof. The grooves may all be of uniform pitch. Alternatively, groove pitch may increase with increasing distance from the center of the polishing pad. Alternatively, groove pitch may decrease with increasing distance from the center of the polishing layer 104. The pitch of the grooves 105 in one sector may vary with increasing distance from the center of the polishing layer 104 while the pitch of the grooves 105 in an adjacent sector remains uniform. The pitch of the grooves 105 in one sector may increase with increasing distance from the center of the polishing layer 104 while the pitch of the grooves in an adjacent sector increases at a different rate. the pitch of the grooves 105 in one sector may increase with increasing distance from the center of the polishing layer 104 while the pitch of the grooves 105 in an adjacent sector decreases with increasing distance from the center of the polishing layer 104. Grooves of uniform pitch may alternate with grooves of variable pitch. Sectors of grooves of uniform pitch may alternate with sectors of grooves of variable pitch.

When the grooves 105 of the polishing layer 104 are formed during a molding process, the positioning of the resulting polishing layer 104 during formation of the polishing layer 104 in a mold may be determined after removal of the polishing layer 104 from the mold. That is, such a polishing layer 104 may be designed (e.g., with clocking marks) to provide traceability back to the molding process. Thus, the polishing layer 104 may be a molded polishing layer, and a feature included therein may indicate a location of a region in a mold used for forming a resulting polishing layer 104.

As a pairing, a combination of the foundation layer 102 and the polishing layer 104 may have an energy loss factor of less than approximately 1000 KEL at 1/Pa at 40°C. The polishing layer 104 may have an elastic storage modulus (E') at 40 degrees Celsius approximately in the range of 50 MPa - 100 MPa, and the foundation layer 102 may have an elastic storage modulus (E') at 40 degrees Celsius approximately in the range of 1500 MPa - 3000 MPa. The foundation layer 102 may have a hardness approximately in the range of 70 - 90 Shore D, and the polishing layer 104 may have a hardness approximately in the range of 20 - 65 Shore D.

As mentioned above, the polishing layer 104 may be attached to the foundation layer 102 by an adhesive layer 116 such as a PSA layer. Alternatively, the polishing layer 104 may be bonded directly to the foundation layer 102. That is, the polishing layer 104 may be in direct contact with the foundation layer 102. "Bonded directly to" may describe direct contact with no intervening layers (such as pressure sensitive adhesive layers) or otherwise glue-like or adhesive films. In which case, the polishing layer 104 is covalently bonded to the foundation layer 102. The term "covalently bonded" may refer to arrangements where atoms from a first material (e.g., the material of a polishing layer) are cross-linked or share electrons with atoms from a second material (e.g., the material of a foundation layer) to effect actual chemical bonding. Covalent bonding is distinguished from mechanical bonding, such as bonding through screws, nails, glues, or other adhesives. The polishing layer 104 may not be covalently bonded, but rather only electrostatically bonded, to the foundation layer 102. Such electrostatic bonding may involve van der Waals type interactions between the foundation layer 102 and the polishing layer 104.

In either case, whether the polishing layer 104 is attached to the foundation layer 102 by an adhesive layer 116 or is bonded directly to the foundation layer 102, peel resistance may provide an indication of the strength and extent to which a polishing layer 104 is coupled with a foundation layer 102. The foundation layer 102 and the polishing layer 104 may have a peel resistance sufficient to withstand a shear force applied during the useful lifetime of the polishing pad 100.

Surface roughness may be used at the interface of the polishing layer 104 and the foundation layer 102 to enhance bond strength of these two portions of the polishing pad 100. The foundation layer 102 may have a surface roughness greater than approximately 1 micrometer Ra (root mean square). The surface roughness may be approximately in the range of 5 - 10 micrometers Ra (root mean square). Alternatively, substantial surface roughness may not be included and the interface of a polishing layer 104, and the foundation layer 102 may be particularly smooth. The strength of such a smooth interface may be independent of surface roughness or may not need further strengthening by the inclusion of such surface roughness. The foundation layer 102 may have a smooth surface with a surface roughness less than approximately 1 micrometer Ra (root mean square).

Materials of polishing layer 104 and corresponding foundation layer 102 may each have defined dimensions suitable to provide desired polishing characteristics, either as individual components or collectively for the polishing pad 100 as an entirety. Referring to Figure 1A, the polishing layer 104 may have a thickness (T) approximately in the range of 2 - 50 mils, and the corresponding foundation layer 102 thickness of approximately 20 mils. The foundation layer 102 may have a thickness and modulus relative to the thickness and modulus of the polishing layer 104 sufficient to dictate the bulk polishing characteristics of the corresponding polishing pad 100. The foundation layer 102 may be sufficiently thick for the corresponding polishing pad 100 to provide die-level polishing planarity, but sufficiently thin for the polishing pad 100 to provide wafer-level polishing uniformity.

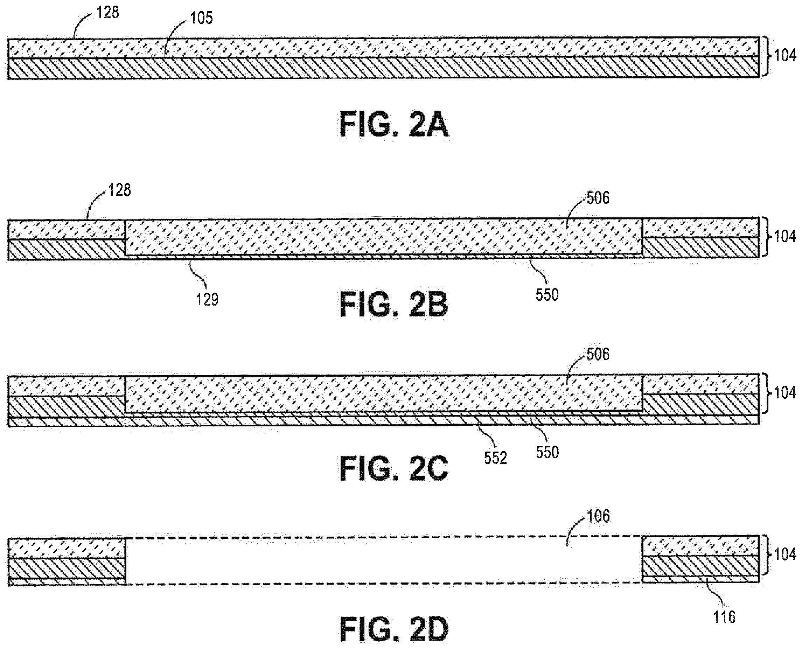

A first exemplary method of fabricating a polishing pad includes attaching a window to a foundation layer subsequent to attaching a polishing layer to the foundation layer. As an example, Figures 2A-2I illustrate cross-sectional views representing various operations in a method of fabricating a polishing pad for polishing a substrate. The methods of fabricating a polishing pad are not part of the invention.

Referring to Figure 2A, a polishing layer 104 is provided. The polishing layer 104 has a polishing side 128 and a back side 129, and has a modulus. The polishing side 128 may have grooves 105 formed therein. Referring to Figure 2D, a first opening 106 is formed through the polishing layer 104. Referring to Figures 2B and 2C, the first opening 106 may be formed by recessing a portion 506 of the polishing layer 104 from the polishing side 128 of the polishing layer 104 but not through to the back side 129 of the polishing layer 104, leaving portion 550. An adhesive layer 552 is then laminated on the back side 129 of the polishing layer 104. Referring again to Figure 2D, the adhesive layer 552 and the back side 129 of the polishing layer 104 are cut in alignment with the recessed portion 506 of the polishing layer 104 to provide the first opening 106 in the polishing layer 104, to remove portion 550, and to leave adhesive layer 116 remaining, as is depicted in Figure 2D. The cutting may be performed using an end mill or a router. Although as described above, the first opening 106 is formed through the polishing layer 104 from the polishing side 128 of the polishing layer 104, the first opening 106 may be formed through the polishing layer 104 from the back side 129 of the polishing layer 104.

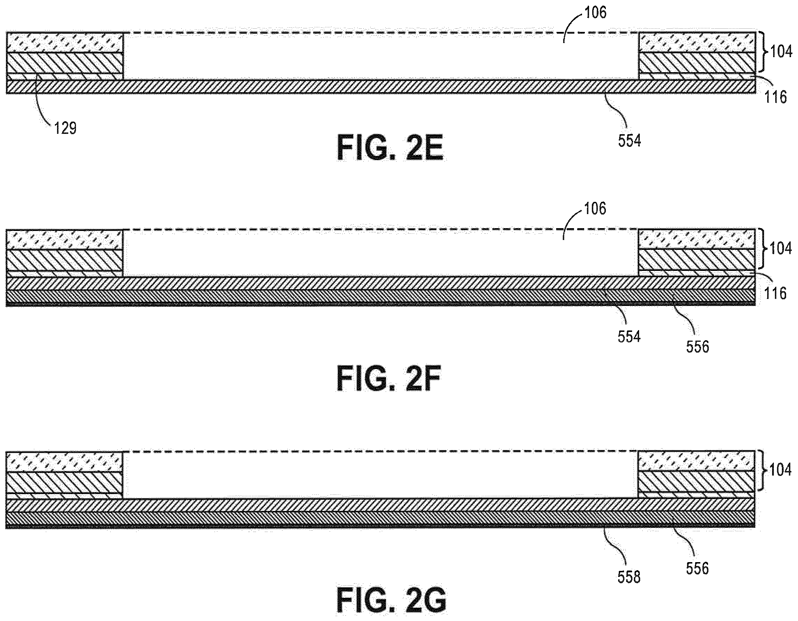

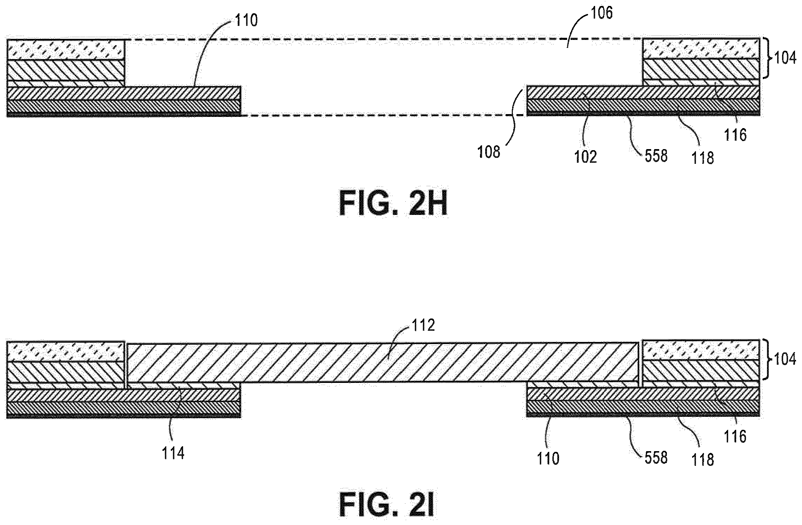

Referring to Figure 2E, a foundation layer 554 is attached to the back side 129 of the polishing layer 104. The foundation layer 554 has a modulus greater than the modulus of the polishing layer 104. Referring to Figure 2H, subsequent to attaching the foundation layer 554 to the back side 129 of the polishing layer 104, a second opening 108 is formed through the foundation layer 554 to provide foundation layer 102 having opening 108 there through. The first opening 106 exposes at least a portion of the second opening 108 and exposes a portion 110 of the foundation layer 102. The first opening 106 may expose the entirety of the second opening 108. Referring to Figures 2F and 2G, prior to forming the second opening 108 through the foundation layer 554, a sub pad 556 and then an adhesive layer 558 may be attached to a side of the foundation layer 554 opposite a side attached to the polishing layer 104. Forming the second opening 108 may also involve forming an opening through in the sub pad 556 (and through adhesive layer 558, if present) to provide sub pad 118, as is depicted in Figure 2H.

Referring to Figure 2I, a window 112 is inserted in the first opening 106 and is attached to the exposed portion 110 of the foundation layer 102. The window 112 may be attached to the exposed portion 110 of the foundation layer 102 with an adhesive layer 114, as was described in association with Figure 1A and as is depicted in Figure 2I. The adhesive layer 114 may first be attached to an outer portion of the window 112 but not to an inner portion of the window 112 (e.g., the outer portion being the portion that contacts the exposed portion 110 of the foundation layer 102), and then attaching the adhesive layer 114 to the exposed portion 110 of the foundation layer 102. The adhesive layer may be one such as, but not limited to, a (PSA) layer, a two-component epoxy layer, a UV-cured resin layer, a silicone-based adhesive layer, a transfer tape layer, or a hot melt layer. The adhesive layer may be a non-differential two-sided tape PSA layer. Alternatively, the adhesive layer may be a differential two-sided tape PSA layer.

The window 112 may be attached to the exposed portion 110 of the foundation layer 102 by welding a portion of the window 112 to the exposed portion 110 of the foundation layer 102, as is described below in association with Figure 3. Alternatively, the window 112 may be attached to the exposed portion 110 of the foundation layer 102 by snap-fitting the window 112 to the foundation layer 102, as is described below in association with Figure 4. the window 112 may be attached to the foundation layer 102 by inserting a portion of the window 112 into a portion of the second opening 108, such as the case for a T-plug, as described above.

A second exemplary polishing pad includes a foundation layer having a window attached to the foundation layer by a welded region. For example, Figure 3 illustrates a cross-sectional view of a polishing pad with a window housed within an opening in a polishing layer and attached to an underlying foundation layer by a welded region.

Referring to Figure 3, a polishing pad 300 for polishing a substrate includes a foundation layer 102 having a first modulus. A polishing layer 104 is attached to the foundation layer 102. The polishing layer 104 has a second modulus less than the first modulus. A first opening 106 is through the polishing layer 104. A second opening 108 is through the foundation layer 102. From a plan view perspective, the first opening 106 exposes at least a portion of the second opening 108 and exposes a portion 110 of the foundation layer 102. The first opening 106 may expose the entire second opening 108.

Referring again to Figure 3, a window 312 is disposed in the first opening 106 and is attached to the exposed portion 110 of the foundation layer 102. The window 312 may be attached to the exposed portion 110 of the foundation layer 102 by a welded region 302. The welded region 302 may be a region such as, but not limited to, a spot weld region, a line weld region, or a multi-line weld region. Other attributes of window 312 may be as described above in association with window 112 of Figures 1A and 1B. Also, other attributes of polishing pad 300 may be as described above in association with polishing pad 100 of Figures 1A and 1B.

Figure 4 illustrates a cross-sectional view of a polishing pad with a window housed within an opening in a polishing layer and attached to an underlying foundation layer by a snap-fit arrangement, in accordance with the present invention.

Referring to Figure 4, a polishing pad 400 for polishing a substrate includes a foundation layer 102 having a first modulus. A polishing layer 104 is attached to the foundation layer 102. The polishing layer 104 has a second modulus less than the first modulus. A first opening 106 is through the polishing layer 104. A second opening 108 is through the foundation layer 102. From a plan view perspective, the first opening 106 exposes at least a portion of the second opening 108 and exposes a portion 110 of the foundation layer 102. In one such embodiment, the first opening 106 exposes the entire second opening 108.

Referring again to Figure 4, a window 412 is disposed in the first opening 106 and is attached to the exposed portion 110 of the foundation layer 102. The window 412 is attached to the exposed portion 110 of the foundation layer 102 by a snap-fit feature 402. The snap-fit feature 402 includes a portion that clamps below a portion of the exposed region 110 of the foundation layer 102. A sub pad 118 has a feature 404 (such as a bevel) for to accommodate, or formed from accommodating, the snap-fit feature 402 of the window 412. Other attributes of window 412 may be as described above in association with window 112 of Figures 1A and 1B. Also, other attributes of polishing pad 400 may be as described above in association with polishing pad 100 of Figures 1A and 1B.

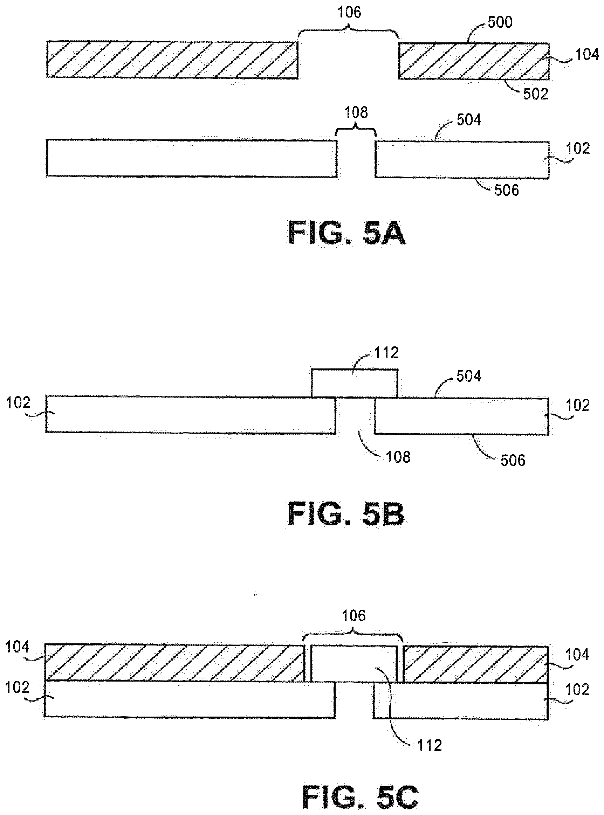

It is to be appreciated that other approaches may be used to fabricate polishing pads, such as polishing pads 100, 300 and 400, in addition or as an alternate to the method described above in association with Figures 2A-2I. A second exemplary method of fabricating a polishing pad includes attaching a window to a foundation layer prior to attaching a polishing layer to the foundation layer. As an example, Figures 5A-5C illustrate cross-sectional views representing various operations in a method of fabricating a polishing pad for polishing a substrate.

Referring to Figure 5A, a first opening 106 is formed through a polishing layer 104. The polishing layer 104 has a polishing side 500 and a back side 502 and has a modulus. A second opening 108 is formed through a foundation layer 102. The foundation layer has a polishing side 504 and a back side 506 and has a modulus greater than the modulus of the polishing layer 104. It is to be appreciated that the ordering of forming the first or second openings can be varied with respect to one another and with respect to other operations described herein.

Referring to Figure 5B, a window 112 is attached to the polishing side 504 of the foundation layer 102. The window 112 covers at least a portion of the second opening 108. In one such embodiment, the window 112 covers the entirety of the second opening 108, as is depicted in Figure 5B.

The window 112 may be attached to the polishing side 504 of the foundation layer 102 with an adhesive layer, as was described in association with Figure 1A. The adhesive layer may first be attached to an outer portion of the window 112 but not to an inner portion of the window 112 (e.g., the outer portion being the portion that contacts the foundation layer 102), and then attaching the adhesive layer to the foundation layer 102. The adhesive layer may be one such as, but not limited to, a (PSA) layer, a two-component epoxy layer, a UV-cured resin layer, a silicone-based adhesive layer, a transfer tape layer, or a hot melt layer. the adhesive layer may be a non-differential two-sided tape PSA layer. The adhesive layer may be a differential two-sided tape PSA layer.

The window 112 may be attached to the polishing side 504 of the foundation layer 102 by welding a portion of the window 112 to the foundation layer 102, as was described in association with Figure 3. The window 112 is attached to the polishing side 504 of the foundation layer 102 by snap-fitting the window 112 to the foundation layer 102, as was described in association with Figure 4. The window 112 may be attached to the foundation layer 102 by inserting a portion of the window into a portion of the second opening, such as the case for a T-plug, as described above.

Referring to Figure 5C, subsequent to attaching the window 112 to the polishing side 504 of the foundation layer 102, the polishing layer 104 is attached to the foundation layer 102. The first opening 106 formed through the polishing layer 104 surrounds the window 112.

Polishing pads described herein, such as polishing pads 100, 300 or 400, are suitable for polishing substrates. The substrate may be one used in the semiconductor manufacturing industry, such as a silicon substrate having device or other layers disposed thereon. However, the substrate may be one such as, but not limited to, a substrates for MEMS devices, reticles, or solar modules. Thus, reference to "a polishing pad for polishing a substrate," as used herein, is intended to encompass these and related possibilities. A polishing pad may have a diameter approximately in the range of 20 inches to 30.3 inches, e.g., approximately in the range of 50 - 77 centimeters, and possibly approximately in the range of 10 inches to 42 inches, e.g., approximately in the range of 25 - 107 centimeters.

Providing context for one or more embodiments described herein, it is to be appreciated that conventional approaches to fabricating and using soft polishing pads may have limitations. For example, casted soft pads may offer low defect characteristics but compromised planarization performance. There may be a need for polishing pads that offer both low defect characteristics yet high planarization performance during polishing operations. Similarly, conventional approaches to fabricating and using hard polishing pads may have limitations. For example, faster gelling speeds possibly inherent in harder urethane formulations may force process compromises that impact pad uniformity and limit formulation options. There may be a need for an approach suitable to produce and implement hard pads that avoid such compromises. Additionally, as noted above, it may be desirable to decouple the properties of the polishing surface of a pad from its bulk properties, such that the properties of each may be separately optimized.

Polishing pads with foundation layers of a material different from the material of the polishing surface are described above. Such polishing pads may be fabricated or implemented in polishing approaches suitable to address the above described compromises made for conventional pads. A composite polishing pad may include a foundation layer fabricated from a stable, essentially non-compressible, inert material to which a polishing layer is attached. A foundation layer having a relatively higher modulus may provide support and strength for pad integrity while a polishing layer having relatively lower modulus may reduce scratching, enabling decoupling of the material properties of the polishing layer and the remainder of the polishing pad.

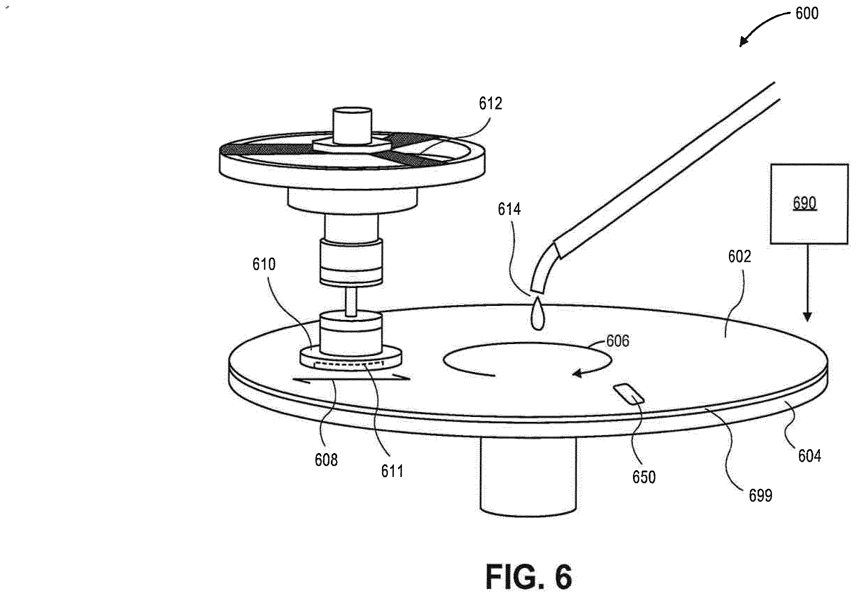

Polishing pads described herein may be suitable for use with a variety of chemical mechanical polishing apparatuses. As an example, Figure 6 illustrates an isometric side-on view of a polishing apparatus compatible with a polishing pad described herein.

Referring to Figure 6, a polishing apparatus 600 includes a platen 604. The upper surface 602 of platen 604 may be used to support a polishing pad 699, such as a polishing pad having a polishing layer and a foundation layer, with a window attached to the foundation layer. Platen 604 may be configured to provide spindle rotation 606. A sample carrier 610 is used to hold a semiconductor wafer 611 in place during polishing of the semiconductor wafer with a polishing pad. Sample carrier 610 may further provide slider oscillation 608. Sample carrier 610 is further supported by a suspension mechanism 612. A slurry feed 614 is included for providing slurry to a surface of the polishing pad 699 prior to and during polishing of the semiconductor wafer. A conditioning unit 690 may also be included and, in one embodiment, includes a diamond tip for conditioning a polishing pad. The polishing pad 699 may include a window 650 through which optical end-point detection may be performed during a CMP process.

## Claims

1. A polishing pad (400) for polishing a substrate, the polishing pad comprising:
a foundation layer (102) having a first modulus;
a polishing layer (104) attached to the foundation layer (102) and having a second modulus less than the first modulus;
a first opening (106) through the polishing layer (104) and a second opening (108) through the foundation layer, the first opening (106) exposing at least a portion of the second opening (108) and exposing a portion of the foundation layer; and
a window (412) disposed in the first opening (106) and attached to the exposed portion of the foundation layer, **characterized in that**
the polishing pad (400) further comprises a sub pad attached to the foundation layer (102) on a side of the foundation layer (102) opposite the polishing layer (104) and a third opening through the sub pad, the third opening substantially sized and aligned with the second opening and
the window (412) is attached to the exposed portion of the foundation layer (102) by a snap-fit feature (402), and wherein the window (412) has a portion extending into the second opening,
wherein the snap-fit feature (402) includes a portion that clamps below a portion of the exposed region of the foundation layer, wherein the sub pad has a feature (such as a bevel) to accommodate, or formed from accommodating, the snap-fit feature (402) of the window.

2. The polishing pad (400) of claim 1, wherein, from a plan view perspective of the polishing layer, the window (412) has substantially a same shape as the first opening,

3. The polishing pad (400) of claim 2, wherein the shape is selected from the group consisting of a circle, an oval, a square, a rectangle, and a rectangle having rounded corners; or
a perimeter of the window (412) is reduced in size at all portions of the perimeter by an amount approximately in the range of 5 - 15 mils relative to a perimeter of the first opening.

4. The polishing pad (400) of claim 1, wherein, with respect to the foundation layer, the window (412) has an uppermost surface lower than an uppermost surface of the polishing layer.

5. The polishing pad (400) of claim 1, wherein, from a plan view perspective of the polishing layer, the first opening (106) has substantially a same shape as the second opening, and wherein a perimeter of the second opening (108) is reduced in size at all portions of the perimeter by an amount approximately in the range of 10 - 500 mils relative to a perimeter of the first opening, wherein optionally the perimeter of the second opening (108) is reduced in size at all portions of the perimeter by an amount approximately in the range of 100 - 300 mils relative to the perimeter of the first opening.

6. The polishing pad (400) of claim 1, wherein any one of the following applies, a) the polishing layer (104) is attached to the foundation layer (102) by an adhesive layer;
b) the polishing layer (104) is attached to the foundation layer (102) through covalent bonding of the polishing layer (104) to the foundation layer;
c) the window (412) comprises a material selected from the group consisting of a polyethylene terephthalate material, a polyurethane material, a cyclic olefin copolymer material, a polycarbonate material, a polyester material, a polypropylene material, and a polyethylene material;
d) the window (412) comprises a material transparent to a broad spectrum irradiation approximately in the range of 300 - 800 nanometers; and
e) the foundation layer (102) has an energy loss factor of less than approximately 100 KEL at 1/Pa at 40°C.

7. The polishing pad (400) of claim 1, wherein any one of the following applies,
a) the foundation layer (102) comprises a material selected from the group consisting of a polycarbonate material, an epoxy board material, a polyurethane material, a composite fiber board, a polymethylmethacrylate (PMMA) material, and a cyclic olefin copolymer material;
b) the polishing layer (104) has an energy loss factor of greater than approximately 1000 KEL at 1/Pa at 40°C;
c) a combination of the foundation layer (102) and the polishing layer (104) has an energy loss factor of less than approximately 1000 KEL at 1/Pa at 40°C; and
d) the polishing layer (104) comprises a thermoset polyurethane material, the foundation layer (102) comprises a polycarbonate layer, and the window (412) comprises a polyethylene terephthalate material.

8. The polishing pad (400) of claim 1, wherein the polishing layer (104) has an elastic storage modulus (E') at 40 degrees Celsius approximately in the range of 50 MPa - 100 MPa, and wherein the foundation layer (102) has an elastic storage modulus (E') at 40 degrees Celsius approximately in the range of 1500 MPa - 3000 MPa; or
the foundation layer (102) has a hardness approximately in the range of 70 - 90 Shore D, and the polishing layer (104) has a hardness approximately in the range of 20 - 65 Shore D.

9. The polishing pad (400) of claim 1, wherein the polishing layer (104) has grooves disposed therein, the grooves formed to a depth of approximately 10%-60% of a total thickness of the polishing layer, wherein optionally the grooves are formed to a depth of approximately half of the total thickness of the polishing layer.

## Patentansprüche

1. Polierkissen (400) zum Polieren eines Substrats, wobei das Polierkissen Folgendes umfasst:
eine Fundamentschicht (102), einen ersten Modul aufweisend;
eine Polierschicht (104), befestigt an der Fundamentschicht (102) und einen zweiten Modul aufweisend, der kleiner als der erste Modul ist;
eine erste Öffnung (106) durch die Polierschicht (104) und eine zweite Öffnung (108) durch die Fundamentschicht, wobei die erste Öffnung (106) zumindest einen Teil der zweiten Öffnung (108) freilegt und einen Teil der Fundamentschicht freilegt; und
ein Fenster (412), angeordnet in der ersten Öffnung (106) und befestigt an dem freiliegenden Teil der Fundamentschicht, **dadurch gekennzeichnet, dass** das Polierkissen (400) ferner ein Unterkissen, das an der Fundamentschicht (102) an einer Seite der Fundamentschicht (102) gegenüber der Polierschicht (104) befestigt ist, und eine dritte Öffnung durch das Unterkissen umfasst, wobei die dritte Öffnung im Wesentlichen wie die zweite Öffnung dimensioniert und mit dieser ausgerichtet ist, und
das Fenster (412) durch ein Einrastmerkmal (402) am freiliegenden Teil der Fundamentschicht (102) befestigt ist, und wobei das Fenster (412) einen Teil aufweist, der sich in die zweite Öffnung erstreckt,
wobei das Einrastmerkmal (402) einen Teil umfasst, der unter einem Teil der freiliegenden Region der Fundamentschicht angeklemmt wird, wobei das Unterkissen ein Merkmal (wie etwa eine Schräge) aufweist, um das Einrastmerkmal (402) des Fensters aufzunehmen, oder das durch Aufnehmen desselben gebildet wird.

2. Polierkissen (400) nach Anspruch 1, wobei, von einer Draufsichtperspektive der Polierschicht, das Fenster (412) im Wesentlichen eine gleiche Form aufweist wie die erste Öffnung.

3. Polierkissen (400) nach Anspruch 2, wobei die Form aus der Gruppe ausgewählt wird, die besteht aus einem Kreis, einem Oval, einem Quadrat, einem Rechteck und einem Rechteck mit abgerundeten Ecken; oder
wobei ein Umfang des Fensters (412) an allen Teilen des Umfangs um einen Betrag etwa im Bereich von 5 - 15 mils relativ zu einem Umfang der ersten Öffnung in seiner Größe verringert ist.

4. Polierkissen (400) nach Anspruch 1, wobei, bezüglich der Fundamentschicht, das Fenster (412) eine oberste Oberfläche aufweist, die tiefer als eine oberste Oberfläche der Polierschicht ist.

5. Polierkissen (400) nach Anspruch 1, wobei, von einer Draufsichtperspektive der Polierschicht, die erste Öffnung (106) eine im Wesentlichen gleiche Form aufweist wie die zweite Öffnung und wobei ein Umfang der zweiten Öffnung (108) an allen Teilen des Umfangs um einen Betrag etwa im Bereich von 10 - 500 mils relativ zu einem Umfang der ersten Öffnung in seiner Größe verringert ist, wobei optional der Umfang der zweiten Öffnung (108) an allen Teilen des Umfangs um einen Betrag etwa im Bereich von 100 - 300 mils relativ zu einem Umfang der ersten Öffnung in seiner Größe verringert ist.

6. Polierkissen (400) nach Anspruch 1, wobei ein Beliebiges aus Folgendem zutrifft: a) die Polierschicht (104) ist durch eine Klebstoffschicht an der Fundamentschicht (102) befestigt;
b) die Polierschicht (104) ist durch kovalente Bindung der Polierschicht (104) mit der Fundamentschicht an der Fundamentschicht (102) befestigt;
c) das Fenster (412) umfasst ein Material, das aus der Gruppe ausgewählt wird, die besteht aus einem Polyethylenterephthalatmaterial, einem Polyurethanmaterial, einem Cycloolefin-Copolymermaterial, einem Polycarbonatmaterial, einem Polyestermaterial, einem Polypropylenmaterial und einem Polyethylenmaterial;
d) das Fenster (412) umfasst ein Material, das transparent für eine breite Spektrumsstrahlung etwa im Bereich von 300 - 800 Nanometern ist; und
e) die Fundamentschicht (102) weist einen Energieverlustfaktor von weniger als 100 KEL bei 1/Pa bei 40 °C auf.

7. Polierkissen (400) nach Anspruch 1, wobei ein Beliebiges aus Folgendem zutrifft,
a) die Fundamentschicht (102) umfasst ein Material, das aus der Gruppe ausgewählt ist, die besteht aus einem Polycarbonatmaterial, einem Epoxidplattenmaterial, einem Polyurethanmaterial, einer Verbundfaserplatte, einem Polymethylmethacrylat- bzw. PMMA-Material und einem Cycloolefin-Copolymermaterial;
b) die Polierschicht (104) weist einen Energieverlustfaktor von mehr als etwa 1000 KEL bei 1/Pa bei 40 °C auf;
c) eine Kombination aus der Fundamentschicht (102) und der Polierschicht (104) weist einen Energieverlustfaktor von weniger als etwa 1000 KEL bei 1/Pa bei 40 °C auf; und
d) die Polierschicht (104) umfasst ein duroplastisches Polyurethanmaterial, die Fundamentschicht (102) umfasst eine Polycarbonatschicht, und das Fenster (412) umfasst ein Polyethylenterephthalatmaterial.

8. Polierkissen (400) nach Anspruch 1, wobei die Polierschicht (104) einen elastischen Speichermodul (E') bei 40 Grad Celsius etwa im Bereich von 50 MPa - 100 MPa aufweist und wobei die Fundamentschicht (102) einen elastischen Speichermodul (E') bei 40 Grad Celsius etwa im Bereich von 1500 MPa - 3000 MPa aufweist; oder
wobei die Fundamentschicht (102) eine Härte etwa im Bereich von 70 - 90 Shore D aufweist und die Polierschicht (104) eine Härte etwa im Bereich von 20 - 65 Shore D aufweist.

9. Polierkissen (400) nach Anspruch 1, wobei die Polierschicht (104) darin angeordnete Nuten aufweist, wobei die Nuten bis zu einer Tiefe von etwa 10 %-60 % einer Gesamtdicke der Polierschicht gebildet sind, wobei optional die Nuten bis zu einer Tiefe von etwa der Hälfte der Gesamtdicke der Polierschicht gebildet sind.

## Revendications

1. Tampon de polissage (400) pour polir un substrat, le tampon de polissage comprenant :
une couche de fondation (102) ayant un premier module ;
une couche de polissage (104) attachée à la couche de fondation (102) et ayant un second module inférieur au premier module ;
une première ouverture (106) à travers la couche de polissage (104) et une deuxième ouverture (108) à travers la couche de fondation, la première ouverture (106) exposant au moins une partie de la deuxième ouverture (108) et exposant une partie de la couche de fondation ; et
une fenêtre (412) disposée dans la première ouverture (106) et attachée à la partie exposée de la couche de fondation, **caractérisé en ce que** le tampon de polissage (400) comprend en outre un sous-tampon attaché à la couche de fondation (102) sur une face de la couche de fondation (102) opposée à la couche de polissage (104) et une troisième ouverture à travers le sous-tampon, la troisième ouverture étant sensiblement dimensionnée et alignée avec la deuxième ouverture, et
la fenêtre (412) est attachée à la partie exposée de la couche de fondation (102) par un dispositif d'ajustement par encliquetage (402), et dans lequel la fenêtre (412) a une partie s'étendant dans la deuxième ouverture,
dans lequel le dispositif d'ajustement par encliquetage (402) inclut une partie qui se serre en dessous d'une partie de la région exposée de la couche de fondation, dans lequel le sous-tampon a une caractéristique (telle qu'un biseau) pour loger le dispositif d'ajustement par encliquetage (402) de la fenêtre, ou formée à partir du logement de celui-ci.

2. Tampon de polissage (400) de la revendication 1, dans lequel, d'une perspective en vue en plan de la couche de polissage, la fenêtre (412) a sensiblement une même forme que la première ouverture.

3. Tampon de polissage (400) de la revendication 2, dans lequel la forme est sélectionnée parmi le groupe constitué de : un cercle, un ovale, un carré, un rectangle, et un rectangle ayant des coins arrondis ; ou un périmètre de la fenêtre (412) est réduit en taille dans toutes les parties du périmètre selon une quantité approximativement dans la plage de 5 à 15 millièmes de pouce relativement à un périmètre de la première ouverture.

4. Tampon de polissage (400) de la revendication 1, dans lequel, par rapport à la couche de fondation, la fenêtre (412) a une surface la plus haute plus basse qu'une surface la plus haute de la couche de polissage.

5. Tampon de polissage (400) de la revendication 1, dans lequel, d'une perspective en vue en plan de la couche de polissage, la première ouverture (106) a sensiblement une même forme que la deuxième ouverture, et dans lequel un périmètre de la deuxième ouverture (108) est réduit en taille dans toutes les parties du périmètre selon une quantité approximativement dans la plage de 10 à 500 millièmes de pouce relativement à un périmètre de la première ouverture, dans lequel, optionnellement, le périmètre de la deuxième ouverture (108) est réduit en taille dans toutes les parties du périmètre selon une quantité approximativement dans la plage de 100 à 300 millièmes de pouce relativement au périmètre de la première ouverture.

6. Tampon de polissage (400) de la revendication 1, dans lequel un quelconque de ce qui suit est vrai, a) la couche de polissage (104) est attachée à la couche de fondation (102) par une couche adhésive ;
b) la couche de polissage (104) est attachée à la couche de fondation (102) par l'intermédiaire de liaison covalente de la couche de polissage (104) à la couche de fondation ;
c) la fenêtre (412) comprend un matériau sélectionné parmi le groupe constitué de : un matériau polyéthylène téréphtalate, un matériau polyuréthane, un matériau copolymère d'oléfines cycliques, un matériau polycarbonate, un matériau polyester, un matériau polypropylène, et un matériau polyéthylène ;
d) la fenêtre (412) comprend un matériau transparent à un rayonnement de large spectre approximativement dans la plage de 300 à 800 nanomètres ; et
e) la couche de fondation (102) a un facteur de perte d'énergie inférieur à approximativement 100 KEL à 1/Pa à 40 °C.

7. Tampon de polissage (400) de la revendication 1, dans lequel un quelconque de ce qui suit est vrai,
a) la couche de fondation (102) comprend un matériau sélectionné parmi le groupe constitué de : un matériau polycarbonate, un matériau panneau époxy, un matériau polyuréthane, un panneau en fibre composite, un matériau polyméthylméthacrylate (PMMA), et un matériau copolymère d'oléfines cycliques ;
b) la couche de polissage (104) a un facteur de perte d'énergie supérieur à approximativement 1 000 KEL à 1/Pa à 40 °C ;
c) une combinaison de la couche de fondation (102) et de la couche de polissage (104) a un facteur de perte d'énergie inférieur à approximativement 1 000 KEL à 1/Pa à 40 °C ; et
d) la couche de polissage (104) comprend un matériau polyuréthane thermo-durci, la couche de fondation (102) comprend une couche de polycarbonate, et la fenêtre (412) comprend un matériau polyéthylène téréphtalate.

8. Tampon de polissage (400) de la revendication 1, dans lequel la couche de polissage (104) a un module de stockage élastique (E') à 40 degrés Celsius approximativement dans la plage de 50 MPa à 100 MPa, et dans lequel la couche de fondation (102) a un module de stockage élastique (E') à 40 degrés Celsius approximativement dans la plage de 1 500 MPa à 3 000 MPa ; ou
la couche de fondation (102) a une dureté approximativement dans la plage de 70 à 90 Shore D, et la couche de polissage (104) a une dureté approximativement dans la plage de 20 à 65 Shore D.

9. Tampon de polissage (400) de la revendication 1, dans lequel la couche de polissage (104) a des rainures disposées dans celle-ci, les rainures étant formées jusqu'à une profondeur d'approximativement 10 % à 60 % d'une épaisseur totale de la couche de polissage, dans lequel, optionnellement, les rainures sont formées jusqu'à une profondeur d'approximativement la moitié de l'épaisseur totale de la couche de polissage.
